# EUROPEAN PATENT APPLICATION

(11) **EP 3 370 262 A1**
(43) Date of publication of application: **05.09.2018**
(21) Application number: 16860099.7
(22) Date of filing: 30.09.2016
(51) Int. Cl.: H01L 31/0392, H01L 21/761, H01L 29/06, H01L 31/05, H01L 31/0224, H05B 33/14

(54) **PN JUNCTION ELEMENT AND ELECTRONIC DEVICE USING SAME**

(30) Priority: 29.10.2015 KR 20150150952
(71) Applicant: Petalux Inc., Seongnam-si, Gyeonggi-do 13438 (KR)
(72) Inventor: AHN, Do Yeol, Seoul 05647 (KR); PARK, Sang Joon, Yongin-si Gyeonggi-do 16928 (KR); SONG, Jin Dong, Seoul 02797 (KR); YANG, Seong Hyun, Yongin-si Gyeonggi-do 17038 (KR)
(74) Representative: Zardi, Marco
(86) International application number: PCT/KR2016/010956
(87) International publication number: WO 2017/073915

(57) **Abstract**

A trasparent PN junction device and an electronic device using the PN junction device are provided. The PN junction device to achieve above objects of the invention includes a support substrate, a capper chloride (CuCl) thin film layer, a transparent electrode layer, a first electrode and a second electrode. The capper chloride thin film layer is formed on the supporting substrate and operates as a P-type semiconductor layer. The transparent electrode layer is formed on the capper chloride thin film layer and operates as an N-type semiconductor layer. The first electrode is formed on the capper chloride thin film layer. The second electrode is formed on the transparent electrode layer. Further, the transparent electrode layer may include indium tin oxide (ITO) or indium zinc oxide (IZO).

## Description

### [Technical Field]

The present invention relates to a PN junction device and an electronic device using the PN junction device, and more particularly, the present invention relates to a PN junction device transparent to visible light and an electronic device using the PN junction device.

### [Background Art]

Today, many electronic devices are being used. In particular, transparent displays and the like are used for displaying movies and dramas, and it is expected to gradually become popular. In order to realize such a transparent electronic device, a transparent PN junction device used as a basic element is essential.

Among these techniques, Korean Patent Laid-Open Publication No. 10-2011-0072231, 'UNIPOLAR VERTICAL TYPE TRANSPARENT DIODE' discloses a unipolar vertical type transparent diode with a substrate, a lower electrode, a ZnO thin film, a ZnMgO thin film and an upper electrode sequentially laminated in order.

Also, Korean Patent Laid-Open Publication No. 10-2011-0014326, 'TRANSPARENT ORGANIC LIGHT EMITTING DIODE DISPLAY DEVICE HAVING SOLAR CELL AND METHOD FOR MANUFACTURING THE SAME', discloses an organic light emitting display (OLED) including a display part having an transparent OLED panel and a driving circuit, a solar cell disposed under the transparent OLED panel to convert light into electric power, and a transparent intermediate layer disposed between the transparent OLED panel and the solar cell to electrically insulate them and to control transmittance of light arriving at the solar cell.

As described above, various technologies for realizing transparent electronic devices has been under development.

### [Detailed Description of the Invention]

### [Objects of the Invention]

Objects of the present invention are to provide a transparent PN junction device and an electronic device using the same.

### [Technical Solution]

A PN junction device to achieve above objects of the invention includes a support substrate, a capper chloride (CuCl) thin film layer, a transparent electrode layer, a first electrode and a second electrode. The capper chloride thin film layer is formed on the supporting substrate and operates as a P-type semiconductor layer. The transparent electrode layer is formed on the capper chloride thin film layer and operates as an N-type semiconductor layer. The first electrode is formed on the capper chloride thin film layer. The second electrode is formed on the transparent electrode layer.

For example, the transparent electrode layer may include indium tin oxide (ITO) or indium zinc oxide (IZO).

For example, wherein the support substrate may be a glass substrate, a quartz substrate, an alumina substrate, a silicon substrate, or a gallium arsenide substrate.

For example, the PN junction device may further include a passivation layer covering the capper chloride thin film layer and the transparent electrode layer such that a portion of the capper chloride thin film layer and a portion of the transparent electrode layer are exposed, and the first electrode and the second electrode may be respectively formed on the capper chloride thin film layer and the transparent electrode layer exposed through the passivation layer.

A solar battery according to an exemplary embodiment of the present invention includes a first substrate, a second substrate facing the first substrate, and a plurality of solar cells connected in series between the first substrate and the second substrate. Each of the solar cell includes a capper chloride (CuCl) thin film layer operating as a P-type semiconductor layer, and a transparent electrode layer formed on the capper chloride thin film layer and operating as an N-type semiconductor layer.

For example, the transparent electrode layer comprises indium tin oxide (ITO) or indium zinc oxide (IZO).

For example, the solar battery may further include an encapsulating material combining the first substrate and the second substrate to protect the solar cell.

A flat panel display according to an exemplary embodiment of the present invention includes a plurality of pixels, each of the pixels including a switching transistor, a driving transistor and a light emitting device. The switching transistor is turned on or off depending on whether a scan signal is applied thereto. A pixel signal is applied to the driving transistor when the switching transistor is turned on. The light emitting device is driven by the driving transistor to emit light. The light emitting device includes a capper chloride (CuCl) thin film layer operating as a P-type semiconductor layer, and a transparent electrode layer formed on the capper chloride thin film layer and operating as an N-type semiconductor layer.

For example, the transparent electrode layer may include indium tin oxide (ITO) or indium zinc oxide (IZO).

For example, wherein each of the pixels further may include a storage capacitor for maintaining light emission of the light emitting device for one frame.

For example, each of the pixels may further include a phosphor layer formed on the transparent electrode layer.

### [Advantageous Effects]

A PN junction device with a capper chloride (CuCl) thin film layer which operates as a P-type semiconductor layer and a transparent electrode layer formed on the capper chloride thin film layer and which functions as an N-type semiconductor layer has a band gap of UV region. Therefore, it is possible to realize an electronic device transparent to visible light, which has good performance.

### [Description of the Drawings]

FIG. 1 is a cross-sectional view illustrating a PN junction device according to an exemplary embodiment of the present invention.
FIG. 2 is a cross-sectional view illustrating a PN junction device according to another exemplary embodiment of the present invention.
FIG. 3 is a cross-sectional view illustrating an exemplary embodiment of a solar cell to which the PN junction device of the present invention is applied.
FIG. 4 is a circuit diagram of a flat panel display according to an exemplary embodiment of the present invention.
FIG. 5 is a cross-sectional view illustrating a flat panel display according to an exemplary embodiment of the present invention shown in FIG. 4.

### [Mode for Invention]

The present invention is described more fully hereinafter with reference to the accompanying drawings, in which example embodiments of the present invention are shown. The present invention may, however, be embodied in many different forms and should not be construed as limited to the example embodiments set forth herein. Rather, these example embodiments are provided so that this disclosure will be thorough and complete, and will fully convey the scope of the present invention to those skilled in the art.

It will be understood that, although the terms first, second, third etc. may be used herein to describe various elements, components, regions, layers and/or sections, these elements, components, and/or sections should not be limited by these terms. These terms are only used to distinguish one element, component, region, layer or section from another region, layer or section. Thus, a first element, component, or section discussed below could be termed a second element, component, or section without departing from the teachings of the present invention.

The terminology used herein is for the purpose of describing particular example embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs.

It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, preferred embodiments of the present invention will be described in detail with reference to the drawings.

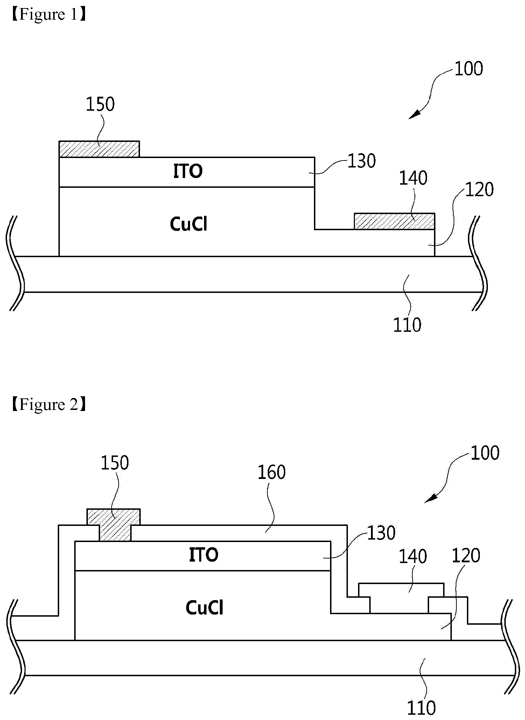

FIG. 1 is a cross-sectional view illustrating a PN junction device according to an exemplary embodiment of the present invention, and FIG. 2 is a cross-sectional view illustrating a PN junction device according to another exemplary embodiment of the present invention.

Referring to FIG. 1, a PN junction device according to exemplary embodiments of the present invention includes a support substrate 110, a capper chloride (CuCl) thin film layer 120, a transparent electrode layer 130, a first electrode 140, and a second electrode 150.

The support substrate 110 may be a glass substrate, a quartz substrate, an alumina substrate, a silicon substrate, or a gallium arsenide substrate.

The capper chloride thin film layer 120 is formed on the support substrate 110 and functions as a P-type semiconductor layer. Although not shown, a buffer layer for growing a capper chloride thin film layer 120 having a good lattice structure may be further formed on the supporting substrate 110, and the capper chloride thin film layer 120 may be formed on the buffer layer (not shown). The buffer layer (not shown) may be composed of, for example, a capper chloride or a transparent single crystal silicon layer.

As shown in [Table 1] below, copper-blended I-VII compound semiconductors has a lattice constant similar to that of silicon, so that a good quality thin film can be formed. More preferably, the n-type semiconductor layer 110 may be formed on the (111) face of the buffer layer.

**[Table 1]**

| | Lattice constant(angstrom (Å)) | Bandgap energy (eV) |
|---|---|---|
| Si | 5.43 | 1.1 (indirect) |
| CuCl | 5.42 | 3.399 |
| CuBr | 5.68 | 2.91 |
| CuI | 6.05 | 2.95 |

Compared with more expensive conventional substrate materials such as sapphire, a silicon buffer layer is firstly formed on a relatively inexpensive glass substrate and then a capper chloride is formed on the buffer layer so that a good quality capper chloride thin film layer can be formed since the silicon and the capper chloride has similar lattice constants.

Further, while silicon is known to have a diamond structure, capper chloride (CuCl) has a zinc blende structure equivalent to a diamond structure. In particular, the (111) plane of the silicon substrate is suitable for the crystal structure of CuCl, which may be stacked on a substrate.

I-VII compound semiconductors can have exciton binding energies that are at least two times greater than those of exciton binding energies, such as Group III nitride, so that quantum efficiency can be improved.

In the present invention, among the I-VII compound semiconductors shown in [Table 1], capper chloride (CuCl) is adopted as a PN junction device, because the band gap energy of CuBr and CuI corresponds to the visible light region so that a portion of the visible light region may be obsorbed. Therefore, CuBr and CuI are not suitable to be used as a complete transparent element.

The transparent electrode layer 130 is formed on the capper chloride thin film layer 120 to serve as an N-type semiconductor layer. For example, the transparent electrode layer 130 may include indium tin oxide (ITO) or indium zinc oxide (IZO).

The first electrode 140 is formed on the capper chloride thin film layer 120 and the second electrode 150 is formed on the transparent electrode layer 130.

Referring to FIG. 2, a PN junction device according to another exemplary embodiment of the present invention may further include a passivation layer 160 covering the capper chloride thin film layer 120 and the transparent electrode layer 130 such that portions of the capper chloride thin film layer 120 and the transparent electrode layer 130 are exposed, comparing the PN junction device of FIG. 1. In this case, the first electrode 140 and the second electrode 150 are formed on the exposed portions of the capper chloride thin film layer 120 and the transparent electrode layer 130, respectively.

Such a PN junction device has excellent quantum efficiency and has a band gap energy of the ultraviolet region band, thereby achieving high quality transparency.

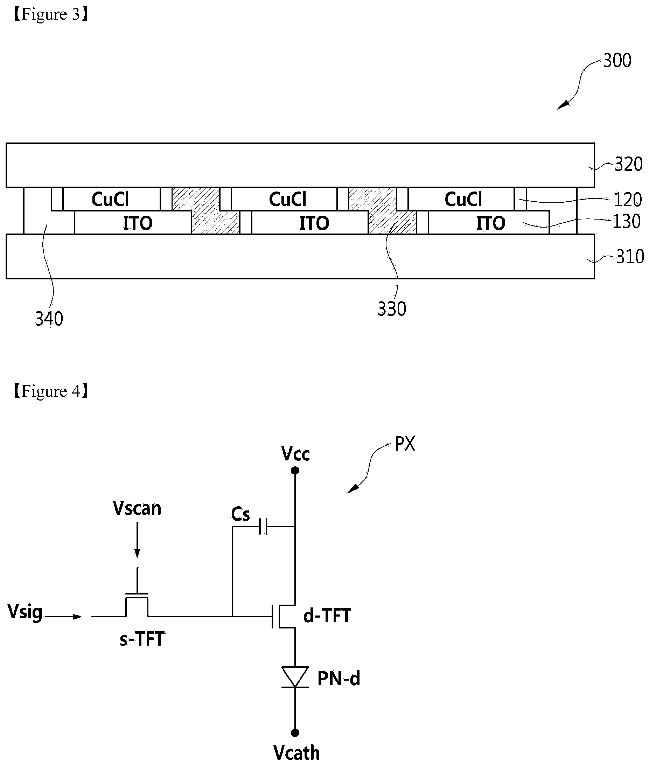

FIG. 3 is a cross-sectional view illustrating an exemplary embodiment of a solar cell to which the PN junction device of the present invention is applied.

Referring to FIG. 3, a solar cell 300 according to an exemplary embodiment of the present invention includes a first substrate 310, a second substrate 320 disposed to face the first substrate 310, and a plurality of solar cells connected in series between the first substrate 310 and the second substrate 320. The solar cell 300 may further include an encapsulant 340 for bonding the first substrate 310 to the second substrate 320 and for protecting the solar cell.

The solar cell includes a capper chloride (CuCl) thin film layer 120 operating as a P-type semiconductor layer, and a transparent electrode layer 130 formed on the capper chloride thin film layer 120 and operating as an N-type semiconductor layer. For example, the transparent electrode layer 130 may include indium tin oxide (ITO) or indium zinc oxide (IZO).

In order to connect the solar cells in series, the solar cell 300 further includes a connection structure 330.

More specifically, the first substrate 310 may be, for example, a transparent substrate, and a glass substrate may be used as the first substrate 310. The transparent electrode layer 130 is formed on the first substrate 310 and the capper chloride thin film layer 120 is formed thereon. At this time, the capper chloride thin film layer 120 may be formed to be offset from each other, and the connection structure 330 connects the transparent electrode layer 130 of the neighboring solar cell with the capper chloride thin film layer 120.

As described above, since the bandgap of the copper chloride (CuCl) thin film layer which operates as a P-type semiconductor layer is in the ultraviolet ray region, the solar cell 300 is transparent to visible light and generates electric power by ultraviolet rays so that the solar cell 300 can be applied to a skylight.

FIG. 4 is a circuit diagram of a flat panel display according to an exemplary embodiment of the present invention.

A flat panel display device according to an exemplary embodiment of the present invention is a flat panel display device including a plurality of pixels PX, and each of the pixels PX includes a switching transistor S-TFT, a driving transistor d-TFT, and a light emitting device PN-d. In addition, each of the pixels PX may further include a storage capacitor Cs for maintaining the light emission of the light emitting device PN-d for one frame.

For example, the plurality of pixels PX may be arranged in a matrix shape along the row direction and the column direction.

For example, the voltage difference (Vcc-Vcath) between the driving voltage Vcc and the cathode voltage Vcath can be fixed to approximately 20 V, and the size of the circuit element can be fixed at a frame rate of 60 Hz.

The switching transistor s-TFT is turned on / off according to whether the scan signal Vscan is applied or not. When the switching transistor s-TFT is turned on, the driving transistor d-TFT receives the pixel signal Vsig. The light emitting device PN-d is driven by the driving transistor d-TFT to emit light. The light emitting device PN-d includes a capper chloride (CuCl) thin film layer that operates as a P-type semiconductor layer and a transparent electrode layer that is formed on the capper chloride thin film layer and operates as an N-type semiconductor layer. For example, the transparent electrode layer may include indium tin oxide (ITO) or indium zinc oxide (IZO).

In order for that, the scan signal Vscan is applied to the gate electrode of the switching transistor s-TFT, and the pixel signal Vsig is applied to the drain electrode of the switching transistor s-TFT. The source electrode of the switching transistor s-TFT is electrically connected to the gate electrode of the driving transistor d-TFT, the drain electrode of the driving transistor d-TFT is electrically connected to the driving voltage Vcc, and the source electrode of the driving transistor d-TFT may be electrically connected to the anode electrode of the light emitting device PN-d.

Also, the cathode electrode of the light emitting device PN-d is connected to the cathode voltage Vcath. The first electrode of the storage capacitor Cs may be electrically connected to the gate electrode of the driving transistor d-TFT and the second electrode of the storage capacitor Cs may be electrically connected to the drain electrode of the driving transistor d- TFT.

Therefore, when the scan signal Vscan is applied to the gate electrode of the switching transistor s-TFT and the pixel signal Vsig is applied to the drain electrode of the switching transistor s-TFT, the pixel signal Vsig is applied to the gate electrode of the transistor d-TFT to turn on the driving transistor d-TFT, so that a current flows between the driving voltage Vcc and the cathode voltage Vcath.

However, this configuration is merely exemplary and may be configured as any circuit for driving the pixel PX employing the light emitting device PN-d.

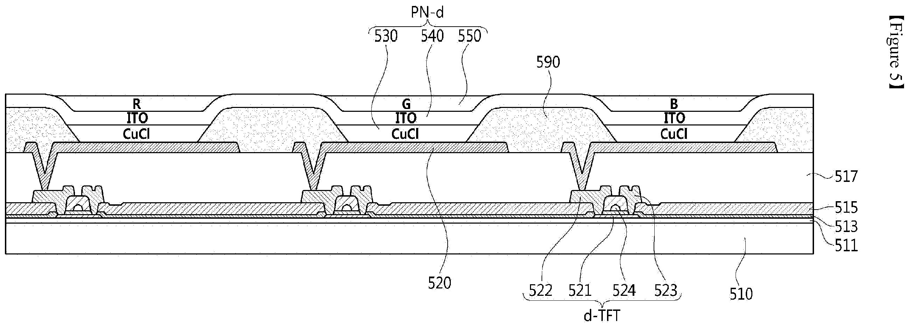

FIG. 5 is a cross-sectional view illustrating a flat panel display according to an exemplary embodiment of the present invention shown in FIG.4.

Referring to FIG. 5, a pixel of a flat panel display according to an exemplary embodiment of the present invention includes a plurality of thin film transistors, and a driving thin film transistor 120 among the plurality of thin film transistors includes a gate electrode 521 disposed on the substrate 100, a source electrode 522, a drain electrode 523, and a semiconductor layer 524. Although only the driving transistor d-TFT is shown in FIG. 5, other switching transistors may have the same structure.

In addition, the driving transistor d-TFT may further include a gate insulating film 513 and an interlayer insulating film 515. The structure of the driving transistor d-TFT is not limited to that shown in FIG. 5, but may be configured in other forms. A buffer layer 511 may further be disposed between the driving transistor d-TFT and the first substrate 100. The buffer layer 511 may be formed of an organic film.

On the driving transistor d-TFT, a planarizing film 517 for insulating and protecting a driving element such as the driving transistor d-TFT is disposed. The planarization film 517 may be formed of an inorganic film or an organic film.

A first electrode 200 is formed on the planarization layer 517. The first electrode 200 is electrically connected to the source electrode 522 of the driving transistor d-TFT.

A pixel defining layer (PDL) 590 is formed between the first electrodes 200. The pixel defining layer 590 is formed of a material having an insulating property to define a pixel region on the first electrode 520. The pixel defining layer 590 may cover end portions of the first electrode 520.

A capper chloride thin film layer 530 is formed on the first electrode 200 exposed between the pixel defining layers 590 independently. A second electrode layer 540 is formed on the capper chloride thin film layer 530. The second electrode layer 540 is composed of a transparent electrode layer including indium tin oxide (ITO) or indium zinc oxide (IZO). As shown in FIG. 4, since the cathode voltage Vcath can apply a common voltage to each pixel, the second electrode layer 540 can be formed so as not to be separated by the pixel defining layer 590, as shown in FIG. 5.

As described referring to FIG. 1, since the capper chloride thin film layer 530 and the second electrode layer 540, which is a transparent electrode layer, have a band gap in the ultraviolet region, UV light is generated between the capper chloride thin film layer 530 and the transparent electrode layer 540.

Accordingly, the light emitting device PN-d further includes a phosphor layer 550 to convert the invisible UV light into visible light. The phosphor layer 550 may be formed of one phosphor layer 550 that emits visible light of the same wavelength. Alternatively, in order to represent a color image, a red phosphor layer R, a green phosphor layer G and the blue phosphor layer B may be formed.

In the case of the phosphor layer 550 that emits visible light of the same wavelength, the phosphor layer 550 is not divided by the pixel defining layer 590 and may be formed as a single layer like the second electrode layer 540. Alternatively, when the phosphor layer 550 includes the red phosphor layer R, the green phosphor layer G and the blue phosphor layer B, the phosphor layer 550 are formed to be divided by the pixel defining layer 590.

As described above, the PN junction device including the capper chloride (CuCl) thin film layer operating as the P-type semiconductor layer and the transparent electrode layer formed on the capper chloride thin film layer and operating as the N-type semiconductor layer, has a bandgap of ultraviolet region, so that an electronic device transparent to visible light of good performance can be realized.

Although the present invention has been described in the detailed description of the invention with reference to exemplary embodiments of the present invention, it will be understood to those skilled in the art that various modifications and variation can be made in the present invention without departing from the spirit or scope of the invention.

## Claims

1. A PN junction device comprising:
a support substrate;
a capper chloride (CuCl) thin film layer formed on the supporting substrate and operating as a P-type semiconductor layer;
a transparent electrode layer formed on the capper chloride thin film layer and operating as an N-type semiconductor layer;
a first electrode formed on the capper chloride thin film layer; and
a second electrode formed on the transparent electrode layer.

2. The PN junction device of claim 1, wherein the transparent electrode layer comprises indium tin oxide (ITO) or indium zinc oxide (IZO).

3. The PN junction device of claim 1, wherein the support substrate is a glass substrate, a quartz substrate, an alumina substrate, a silicon substrate, or a gallium arsenide substrate.

4. The PN junction device of claim 1, further comprising a passivation layer covering the capper chloride thin film layer and the transparent electrode layer such that a portion of the capper chloride thin film layer and a portion of the transparent electrode layer are exposed, and wherein the first electrode and the second electrode are respectively formed on the capper chloride thin film layer and the transparent electrode layer exposed through the passivation layer.

5. A solar battery comprising:
a first substrate;
a second substrate facing the first substrate; and
a plurality of solar cells connected in series between the first substrate and the second substrate,
wherein each of the solar cell comprises:
a capper chloride (CuCl) thin film layer operating as a P-type semiconductor layer; and
a transparent electrode layer formed on the capper chloride thin film layer and operating as an N-type semiconductor layer.

6. The solar battery of claim 5, wherein the transparent electrode layer comprises indium tin oxide (ITO) or indium zinc oxide (IZO).

7. The solar battery of claim 5, further comprising an encapsulating material combining the first substrate and the second substrate to protect the solar cell.

8. A flat panel display with a plurality of pixels, each of the pixels comprising:
a switching transistor that is turned on or off depending on whether a scan signal is applied thereto;
a driving transistor to which a pixel signal is applied when the switching transistor is turned on; and
a light emitting device driven by the driving transistor to emit light;
wherein the light emitting device comprises
a capper chloride (CuCl) thin film layer operating as a P-type semiconductor layer; and
a transparent electrode layer formed on the capper chloride thin film layer and operating as an N-type semiconductor layer.

9. The flat panel display of claim 8, wherein the transparent electrode layer comprises indium tin oxide (ITO) or indium zinc oxide (IZO).

10. The flat panel display of claim 8, wherein each of the pixels further comprises a storage capacitor for maintaining light emission of the light emitting device for one frame.

11. The flat panel display of claim 8, wherein each of the pixels further comprises a phosphor layer formed on the transparent electrode layer.
